Europäisches Patentamt

(19) European Patent Office

Office européen des brevets

(11) Publication number: **0 430 842 A2**

## EUROPEAN PATENT APPLICATION

(21) Application number: 90480154.5

(22) Date of filing: 09.10.90

(51) Int. Cl.⁵: **H05K 3/22**

(30) Priority: 27.11.89 US 441496

(43) Date of publication of application:
05.06.91 Bulletin 91/23

(84) Designated Contracting States:
DE FR GB

(71) Applicant: INTERNATIONAL BUSINESS
MACHINES CORPORATION
Armonk, NY 10504 (US)

(72) Inventor: Hays, Thomas John
1816 Northern Valley Drive N. E.
Rochester, Minnesota 55904 (US)
Inventor: Parry, Donovan Armin
1862 19th Street N. W.
Rochester, Minnesota 55901 (US)
Inventor: Reis, Robert James
1916 Third Avenue S. W.
Rochester, Minnesota 55902 (US)
Inventor: Scrabeck, Larry Dean
Rural Route 1, Box 275
Spring Valley, Minnesota 55975 (US)

(74) Representative: Vekemans, André
Compagnie IBM France Département de
Propriété Intellectuelle
F-06610 La Gaude (FR)

(54) **Apparatus and method for reworking printed wire circuit boards.**

(57) A flexible applique or patch (30) is used to
modify a circuit board (10) by attaching the
flexible applique to the back side of a circuit
board needing rework. The flexible applique
has circuit paths (28') on both its front and back
side. The flexible applique also has circuit paths
which pass from the front side to the back side
of the applique or patch. If additional electrical
components are required by the rework, the
back side of the applique or patch is provided
with pads to which surface mount electrical
components are easily attached. Implementing
the rework using the applique or patch is simple
and easy. The front side of the patch is posi-
tioned on the back side of the circuit board, and
then attached to the back of the circuit board
either by soldering down points along the edge
of the patch or by providing an adhesive on the
front side of the patch. Using this method, both
simple and complex reworks can be quickly
accomplished.

EP 0 430 842 A2

# APPARATUS AND METHOD FOR REWORKING PRINTED WIRE CIRCUIT BOARDS

After initial development of a complex printed wire circuit board, it may be necessary to modify the printed wire circuit board for a variety of reasons. Such a modification generally requires the addition of circuit paths and may require additional components. In a manufacturing environment, many boards may have been produced and all will need to be modified. In addition, incorporating the necessary modification within a particular board generally requires a considerable amount of time so modified boards may have to be produced until the necessary change can be implemented.

Presently, there are several methods for implementing these changes. Each method has shortcomings associated with it. The oldest method for implementing modifications on a printed wire circuit board is to solder wires to the various points, both pads and posts, on the back of the board. Soldering these wires is not only time consuming but also results in a congested spaghetti-like mass of wires on the back of the board. The mass of wires is almost impossible to service in the event that the modification is done incorrectly. In addition, any one of the wires may catch on another object as the board is inserted into a machine and if a wire does catch, a failure may not occur until many months afterwards.

If one or more components are required to carry out the modification, each component must be glued to an uncongested spot on the back of the circuit board with the connecting pins positioned away from the surface of the circuit board. A microscope must then be used to solder the wires on the board to the pins of the component. This method takes time and is prone to shorts between the pins. If free space is available, components may also be added by drilling new openings in the circuit board and attaching the new component. Still another option is to use existing openings in which case the previous electrical connections must be broken and rewired to the proper connection and the new component must also be wired. Each of these options is unavailable on a crowded board.

Several other methods employ a new card of one type or another. An example of this method is shown on page 2050 in Volume 18, No. 7 of the IBM Technical Disclosure Bulletin in which a printed circuit card is modified by attaching a carrier and an overlay board carrying the additions to the original printed circuit card. Elastomer pins are used to make the electrical contacts between the original printed circuit card and the new card. The shortcoming with these types of arrangements is that the thickness of the card is doubled or tripled. In addition, assembly of the three cards is time consuming.

Several other methods either use a card with additional circuit paths, such as an additional pad and circuit path for each pin of a component. If such additions are not needed, then they are eliminated by conventional means such as scribing. This method wastes materials since the additions are not necessarily needed and also wastes space on a printed wire board.

A method similar to adding extra circuit paths is described by S. Picard on page 246 of Volume 15, No. 1 of the IBM Technical Disclosure Bulletin (June 1972). In this method two plastic sheets are used to modify a printed wire board. A first sheet has no circuitry printed on it and serves as an insulator. A second sheet has a preprinted, universal pattern of lands, via holes and conductive paths. To achieve the desired modifications, conductive paths, lands and any other metallization is eliminated. The first and second sheets are attached to the printed wire circuit card to be modified. This method wastes metal and also is very limited in the number of additional circuit paths that can be produced.

Another method and apparatus for modifying circuit cards is described in U.S. Patent No. 4,731,704. In this patent, a thin support plate having electrical conductors on a single side is used to modify a printed circuit board. The thin support plate is attached to the conductor side of the originally manufactured PC board with eyelets that are not connected electrically but are located at the corners of the thin support plate. Any additional components needed to modify the original printed wire circuit board are mounted to the original PC board in the same manner as the original components were mounted. New component mounting holes are drilled in the original circuit board, the leads from the new component are placed through the new component mounting holes and the leads from the new component are attached to the back of the circuit board. The shortcomings associated with Lochner generally do with the size of the modification that can be accomplished. For example, when the original circuit board is crowded with components it precludes a modification which requires an extra component. In addition, modifications which require a number of extra electrical connections in a limited area may be physically impossible to accomplish. In other words, a modification that requires fifty new circuit paths could be impossible since all fifty connections can not be routed on one side of the thin support plate.

Thus, there is a need for a method and apparatus which allows for making quick and easy modifications to a circuit board and which allows for both simple and complex modifications to the original circuit board. In addition, there is a need for a method and apparatus which permits components to be added quickly and easily to an original circuit board populated with components. There is also a need to keep the modified circuit board about as thin as the original circuit board so it will fit within the same space as the original circuit board.

A method and apparatus for modifying original printed circuit cards is disclosed. Circuit paths are placed on both sides of a thin flexible material. Circuit paths are also pass through the thin flexible material. If additional electrical components are needed for the modification, pads are placed on one side of the thin flexible material. An insulative layer is placed on at least one side of the thin flexible material. The thin flexible material is then attached to the back side of the original printed wire circuit board. The insulated side of the thin flexible material is placed onto the back side of the original printed wire board. Once the thin flexible material is attached, any components necessary to complete the modification are attached to the pads on the thin flexible material. Another option is to place the components onto the thin flexible material and then to place the insulated side of the thin flexible material onto the original printed wire board.

This method and apparatus is advantageous due to the ease with which a technician can implement a modification. Additional components, if needed, are merely soldered to pads on the thin flexible material. In addition, more conductor paths can be added using this method as compared to other methods since both sides of the thin flexible material can be used for conductor paths and since conductor paths can pass through the thin flexible material. This allows much more complex modifications to be implemented. The flexible applique is merely attached using an adhesive or by soldering down the edges.

Other advantages stem from the simplicity and ease associated with the method and apparatus disclosed as well as the method and apparatus' ability to allow for much more complex modifications. Using the disclosed method, many more components can be added to the board. In addition, a board can be modified without having to go through a total redesign of the entire board. This method also allows for the addition of portions of a layer in a circuit board. The simplicity and ease associated with using this method and apparatus also allow additional time for a redesign when it is determined one is needed. In other words, the present boards can be modified much more cost effectively thus relieving some of the time pressures associated with doing a redesign of a board when other rework methods are used.

For a better understanding of the present invention, reference may be had to the accompanying drawings in which :

Fig. 1 is a side cut away view of a typical printed wire circuit board.

Fig. 2 is a bottom view of a typical printed wire circuit board.

Fig. 3 is a top view of the first side of the thin flexible applique or patch used to modify the printed wire circuit of Figs. 1 and 2.

Fig. 4 is a top view of the second side of the thin flexible applique or patch used to modify the printed wire circuit of Figs. 1 and 2.

Fig. 5 is a side cut away view of the thin flexible applique or patch having a via therein.

Fig. 6 is a top planar view of a portion of the thin flexible applique or patch.

Fig. 7 is a flow diagram showing the process used to make the thin flexible appliques or patches.

Fig. 8 is a side cut away view of the typical printed wire board as modified using the thin flexible applique or patch.

These drawings are not intended as a definition of the invention but are provided solely for the purpose of illustrating the preferred embodiment of the invention described below.

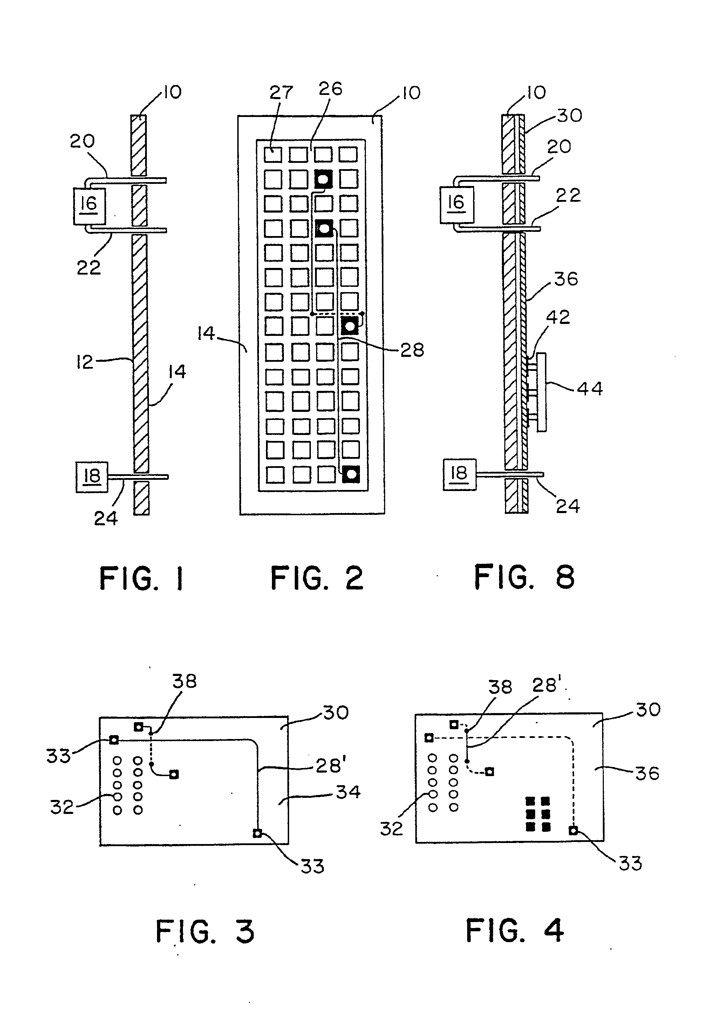

Illustrated in Figs. 1 and 2 are a cross sectional view and a bottom view of a typical printed wire circuit board 10, having a front side 12 and a back side 14. The circuit board 10 is populated with electrical components 16 and 18. The electrical components are physically located on the front side 12 of the circuit board 10. Electrical component 16 has two leads, 20 and 22, which extend through the circuit board 10 from the front side 12 to the back side 14. The leads, 20 and 22, are attached to the back side 14 of the circuit board 10. Similarly, electrical component 18 has a lead 24 which extends through the circuit board 10 and is attached to the back side 14 of the circuit board 10. Typically, a circuit board will be populated with many more components. Two components are shown here for the sake of simplicity.

Fig. 2, shows the back side 14 of the circuit board 10 in more detail. The back side 14 of the circuit board 10 has a series of channels 26 which form a grid. The channels 26 are the areas of the circuit board 10 in which the circuit paths or lands 28 are placed so that electrical contact with the leads 20, 22 and 24 is prevented. Leads 20, 22, and 24 terminate in circular or square areas 27 bounded by four of the channels 26. The back side 14 of the circuit board 10 is typically covered with an electrically insulative layer (not shown).

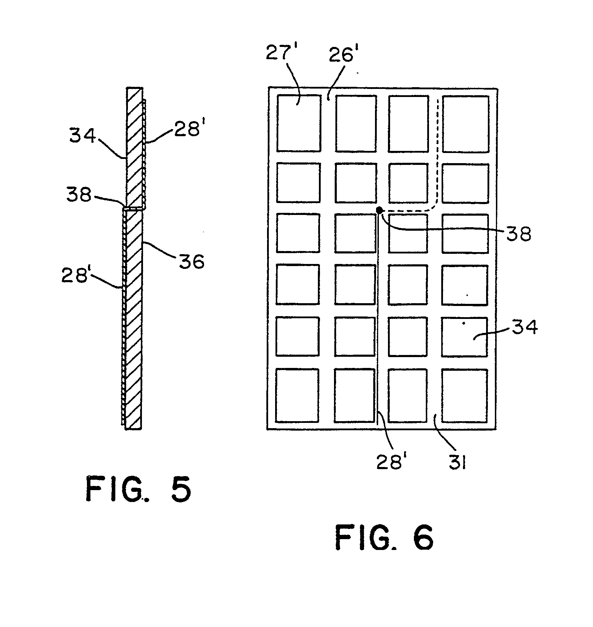

Figs. 3 through 6 show a flexible applique or patch 30 which is used to modify a circuit board such as the one shown in Figs. 1 and 2. The flexible applique 30 is made of a material known as prepreg (preimpregnated material). The flexible applique 30 includes a series of channels 26' which form a grid having square areas 27' which are bounded by four channels 26'. The channels 26' and the grid formed have the same dimensions as the channels 26 and grid formed on the back side 14 of the circuit card 10.

The flexible applique 30 also has component clearance openings 32 and component connector openings 33 therein. The component clearance openings 32 are positioned so that leads from electrical components, such as 20, 22, and 24, from the original circuit card 10 pass through the flexible applique 30. The component connector openings 33 are bounded by a conductive copper pad and are positioned so that the leads from electrical components are electrically attached such as by soldering. The component clearance openings 32 have a larger diameter than the component connector openings 33. Both the component clearance openings 32 and the component connector openings 33 are positioned in the square areas 27' bounded by the channels 26'. Component clearance openings 32 are used when no electrical contact is to be made with a particular lead from an electrical component. Copper circuit paths or lands 28' are attached to both the top side 34 and the bottom side 36 of the flexible applique 30. The circuit paths or lands 28' run within the channels 26' on both the top side 34 and the bottom side 36 of the flexible applique 30.

In many instances, it is advantageous to have a circuit path pass from the top side 34 to the bottom side 36 of the applique 30. The chief advantage associated with having circuit paths pass from the top side 34 to the bottom side 36 is that a much more complex modification to the circuit 10 can be achieved using the flexible applique 30. The flexible applique 30 has a through hole or via 38 therein which provides the conductive path from the top side 34 of the applique 30 to the bottom side 36. The through hole or via 38 is plated with a conductive material such as copper. The result is a copper tube or barrel which extends through flexible applique 30. A land 28' on the top side 34 is in electrical contact with the through hole or via 38 and a land 28' on the bottom side 36 is in electrical contact with the same via 38.

The through holes or vias 38 are positioned so as to prevent an undesirable short with a pad on the original circuit card 10. Through holes or vias 38 are generally positioned on the flexible applique 30 at the center 40 of the intersection of two channels 26'. This position assures that a through hole or via 38 is positioned away from any leads which pass through the board and terminate in the square areas 27' bounded by the channels 26' in the grid pattern. This position is generally referred to as the interstitial position.

In some instances, as shown in Fig. 8, an electrical component 44 is needed to modify the circuit board 10. In such an instance, a surface mount type electrical component can easily be added to modify the original circuit board 10. The flexible applique is provided with a plurality of pads 42 placed on the top side 34 of the flexible applique 30. The pattern of the pads 42 corresponds to the pattern necessary to receive the pins from the desired surface mount electrical component. Of course, circuit paths or lands 28 are electrically connected to the pads 42 so as to incorporate a desired surface mount electrical component into the modification.

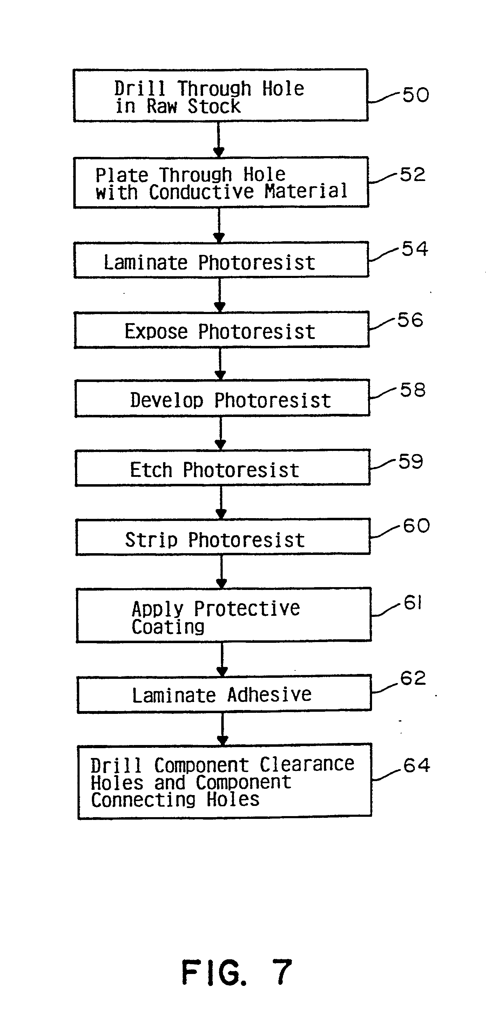

Now referring to Fig. 7, flexible appliques having conductive paths on two sides are formed from a flexible sheet that is coated with a layer of conductive material, such as copper. The flexible sheet coated with the conductive material is generally referred to as raw stock. Drilling the through holes 38 in the raw stock is the initial step in forming flexible appliques having conductive paths on two sides. The next step 52 in making the two-sided applique is to plate the through holes 38 with the conductive material, such as copper. The through holes 38 are plated as a positive electrode in a solution or with an electroless process. Both of these plating processes are well known in the art. The through holes are plated at this point in the process since the aspect ratio of the through hole diameter with respect to the thickness of the flexible sheet in its raw stock form is low as compared to plating of similar through holes when forming a multilayered circuit board, such as circuit board 10 of Fig. 1. The lower aspect ratio indicates that through hole 38 in the flexible sheet can be plated in a shorter time and with little waste attributed to plating of other areas of the raw stock.

The remaining steps in the process of forming the flexible appliques parallel conventional steps for forming conductive paths in circuit boards. Photoresist is then laminated onto the raw stock as depicted by step 54. The photoresist is then exposed, as depicted by step 56. The photoresist is then developed as shown by step 58. The raw stock is then etched as shown by step 59, and stripped as shown by step 60. A protective coating is then applied to flexible sheet, as shown by step 61. In step 62, the entire flexible sheet as processed is then laminated with an adhesive. Finally, component clearance holes and component connector holes are drilled as shown by step 64.

To carry out the modification using the completed flexible applique 30, the bottom side 36 of the applique is positioned and applied to back side 14 of the original circuit board 10. The flexible applique 30 is then attached at the corners and intermittently along the edges of the flexible applique 30 by soldering. An adhesive may be applied to the bottom side 36 of the flexible applique 30 before positioning and applying the applique to the back side 14 of the original circuit board. The adhesive between the bottom side 36 of the flexible applique and the back side 14 of the circuit card 10 can also be used to electrically insulate the circuitry of the flexible applique from the circuitry on the back side 14 of the original circuit card 10. When an adhesive is applied, a two part system comprised of an adhesive and a paper backing covering the adhesive until it is removed is used. Pads associated with the component connector openings in the flexible applique 30 are then soldered to the original electrical components and other desired portions of the original circuit board 10. If electrical components are to be included in the modification, surface mount type electrical components can then be attached to pads that were formed on the top side 34 of the flexible applique 30.

The present invention and the best modes of practicing it have been described. It should be noted that the above described technique can be extended to other electronic structures such as mother boards, multichip modules or any electronic assembly with solder attachment points that require component or wiring changes. It is to be understood that other means and techniques can also be employed without departing from the full scope of the invention as described in the appended claims.

## Claims

1. A flexible applique for modifying a circuit board having a front side and a back side, the circuit board also including electrical components which further include leads that pass through the circuit board, the electrical components positioned on the front side and the electrical leads attached to the back side of the circuit board, the back side of the circuit board further including conductive paths some of which are attached to the leads for the electrical components, the flexible applique comprising :

   a flexible sheet having a first side and a second side and having at least one opening therein which passes from the first side to the second side of the flexible sheet ;
   at least one conductive path attached to the first side of the flexible sheet having one end coterminous with the opening which passes from the first side to the second side of the flexible sheet ;
   at least one conductive path attached to the second side of the flexible sheet having one end coterminous with the opening which passes from the first side to the second side ;
   a layer of conductive material attached to the surface of the flexible sheet formed by the opening in the flexible sheet which passes from the first side to the second side of the flexible sheet thereby forming a conductive through path between the conductive path on the first side of the flexible sheet and the conductive path on the second side of the flexible sheet ; and
   an electrically insulative layer placed on one of the first or second sides of the flexible sheet, the flexible applique being attached to the back side of the circuit board in order to modify the circuit board, the electrically insulative layer placed on the side of the flexible sheet which is attached to the circuit board.

2. The flexible applique as defined in Claim 1 wherein the conductive through path in the flexible sheet is positioned so as to be isolated from the areas on the back side of the circuit board where the leads are attached.

3. The flexible applique as defined in Claim 1 wherein the insulative layer is a layer of adhesive.

4. The flexible applique as defined in Claim 2 wherein the flexible sheet has large openings therein positioned to correspond to the areas on the back side of the circuit board where the leads are attached, the large openings preventing electrical contact with these areas.

5. The flexible applique as defined in Claim 4 further comprising a pad positioned to correspond to an area on the back side of the circuit board where one of the leads is attached, the flexible sheet having an opening therein for receiving the lead, the pad being attached to the lead to place the pad into electrical contact with the lead.

6. The flexible applique as defined in Claim 1 further comprising a pad on the side of the applique positioned opposite the insulated side of the flexible applique, the pads adapted to receive the leads from a surface mount electrical component.

7. A method of producing a flexible applique having a conductive path from a first side of the flexible applique to a second side of the flexible applique, said method comprising the steps of :

   drilling a through hole in a flexible sheet of material which is plated with a layer of conductive material ;
   plating the through hole with conductive material ;
   removing the layer of conductive material on the first side and the second side of the flexible sheet of material to produce the desired pattern of lands and pads on the first and second sides of the flexible sheet of material; and
   drilling component clearance holes and component connector holes in the desired positions.

8. A method of modifying a circuit board which has a front side and a back side, the method of modifying the circuit board comprising the steps of :

producing a flexible applique having pads on the first surface of the flexible applique ; attaching the second surface to the back side of a circuit board ; and attaching a surface mount electrical component to the pads on the first surface of the flexible applique.

FIG. 1    FIG. 2    FIG. 8

FIG. 3    FIG. 4

FIG. 5

FIG. 6

```
┌─────────────────────────┐
│   Drill Through Hole    │──50
│      in Raw Stock       │
└─────────────────────────┘
            │
            ▼
┌─────────────────────────┐
│   Plate Through Hole    │──52
│ with Conductive Material│
└─────────────────────────┘
            │
            ▼
┌─────────────────────────┐
│   Laminate Photoresist  │──54
└─────────────────────────┘
            │
            ▼
┌─────────────────────────┐
│    Expose Photoresist   │──56
└─────────────────────────┘
            │
            ▼
┌─────────────────────────┐
│   Develop Photoresist   │──58
└─────────────────────────┘
            │
            ▼
┌─────────────────────────┐
│     Etch Photoresist    │──59
└─────────────────────────┘
            │
            ▼
┌─────────────────────────┐
│     Strip Photoresist   │──60
└─────────────────────────┘
            │
            ▼
┌─────────────────────────┐
│    Apply Protective     │──61
│        Coating          │
└─────────────────────────┘
            │
            ▼
┌─────────────────────────┐
│    Laminate Adhesive    │──62
└─────────────────────────┘
            │
            ▼
┌─────────────────────────┐
│ Drill Component Clearance│──64
│  Holes and Component    │
│   Connecting Holes      │
└─────────────────────────┘
```

# FIG. 7